Europäisches Patentamt

European Patent Office

Office européen des brevets

(19)

(11) **EP 0 941 479 B1**

(12) **EUROPÄISCHE PATENTSCHRIFT**

(45) Veröffentlichungstag und Bekanntmachung des Hinweises auf die Patenterteilung:
**05.06.2002 Patentblatt 2002/23**

(51) Int Cl.$^7$: **G01R 19/00**

(21) Anmeldenummer: **97951789.3**

(22) Anmeldetag: **19.11.1997**

(86) Internationale Anmeldenummer:
**PCT/DE97/02722**

(87) Internationale Veröffentlichungsnummer:
**WO 98/25149 (11.06.1998 Gazette 1998/23)**

(54) **SCHALTUNGSANORDNUNG ZUR GENAUEN ERFASSUNG EINES AUS GETAKTETEN ELEKTRISCHEN EINGANGSGRÖSSEN ABGELEITETEN GLEICHSTROMES**

CIRCUIT ARRANGEMENT FOR ACCURATELY SENSING A DIRECT CURRENT DERIVED FROM CLOCKED ELECTRIC INPUT VALUES

AGENCEMENT DE CIRCUITS POUR DETECTER AVEC PRECISION UN COURANT CONTINU DERIVE DE VALEURS D'ENTREE ELECTRIQUES SYNCHRONISEES

(84) Benannte Vertragsstaaten:
**AT CH DE ES FR GB IT LI**

(30) Priorität: **02.12.1996 DE 29620919 U**

(43) Veröffentlichungstag der Anmeldung:
**15.09.1999 Patentblatt 1999/37**

(73) Patentinhaber: **SIEMENS AKTIENGESELLSCHAFT**
**80333 München (DE)**

(72) Erfinder: **RAMPOLD, Andreas**
**D-09648 Mittweida (DE)**

(56) Entgegenhaltungen:
**EP-A- 0 612 141      DE-A- 3 337 699**
**DE-B- 2 839 190**

• **HERMAN ET AL.: "A method of continious current sensing in switchmode circuits" MOTOROLA TECHNICAL DEVELOPMENTS, Bd. 7, Oktober 1987, SCHAUMBURG, ILLINOIS, USA, Seiten 60-61, XP002060400**

## Beschreibung

Zur Erfassung eines Stromes wird dieser meist zunächst in eine proportionale Spannung umgewandelt und dann weiterverarbeitet. Die klassische Methode bei der weiteren Auswertung besteht darin, einen Spannungsabfall auszuwerten, welcher von einem zu messenden Strom an einem Meßwiderstand verursacht wird. Hierbei treten allerdings mit steigenden Strömen Probleme auf. Je nach Dimensionierung des Meßwiderstandes tritt entweder eine hohe Verlustleistung auf, oder es muß zur Begrenzung der Verlustleistung mit kleineren Meßspannungen gearbeitet werden. Hierdurch wird aber die Meßgenauigkeit beeinträchtigt.

Durch die DE-A-2 839 190 ist eine Schaltungsanordnung zur Strombegrenzung in Stromversorgungsgeräten, die einen eine Primärwicklung und eine davon galvanisch getrennte Sekundärwicklung aufweisenden Stromwandler enthält, bekannt. Bei diesen Geräten erfolgt eine kombinierte schnelle Momentan- und Mittelwert-Strombegrenzung durch eine gesteuerte Umschaltung einer von der Bürdenspannung abgeleiteten Steuerspannung in Abhängigkeit von dem in einem Integrator gebildeten Mittelwert der Bürdenspannung.

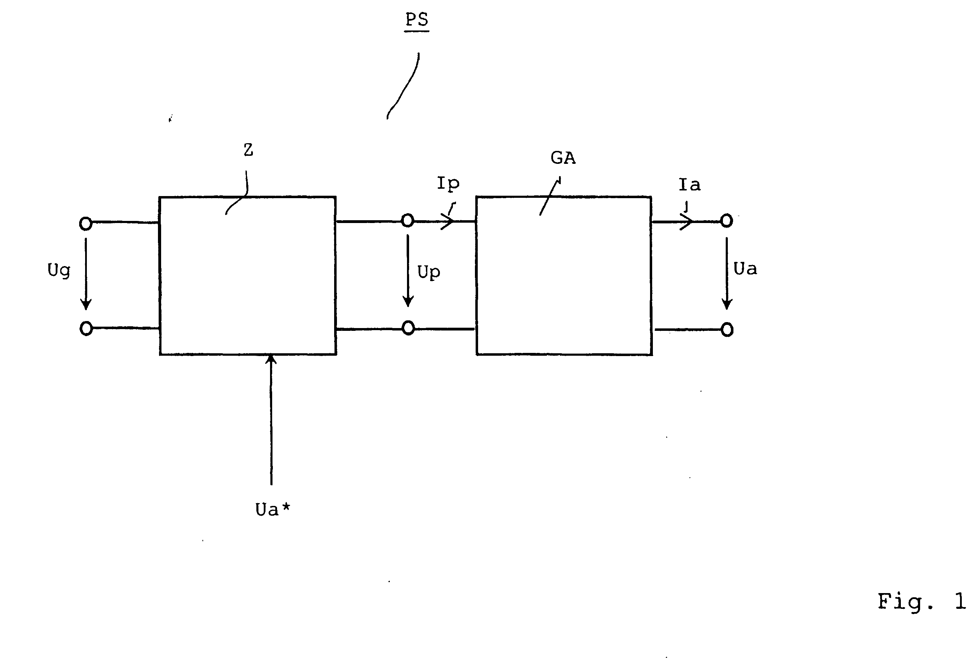

Ein besonderer Fall liegt vor, wenn der zu messende Gleichstrom aus getakteten elektrischen Eingangsgrößen abgeleitet ist. In der Figur 1 ist das Blockschaltbild einer hierzu geeigneten Schaltung dargestellt. Es handelt sich hierbei um die Grundschaltung eines sogenannten Pulsstellers PS. Dieser enthält einen Zerhacker Z, welcher von einer Eingangsgleichspannung Ug gespeist wird. Der Zerhacker Z erzeugt hieraus eine gepulste Zwischenspannung Up und einen gepulsten Zwischenstrom Ip, welcher einen z.B. trapezförmigen Verlauf aufweist. An den Zerhacker Z schließt sich eine Glättungseinrichtung GA für die Zwischenspannung Up und den Zwischenstrom Ip an, welche die gepulsten Größen in eine Ausgangsgleichspannung Ua und einen Ausgangsgleichstrom Ia umwandelt. Dem Zerhacker Z wird ein Sollwert Ua* für die aktuell gewünschte Größe der Ausgangsgleichspannung Ua vorgegeben. Hierüber wird im wesentlichen die Frequenz der Pulse von Zwischenspannung Up und Zwischenstrom Ip am Ausgang des Zerhakkers Z so beeinflußt, daß die Zwischenspannung Up einen gewünschten Wert annimmt.

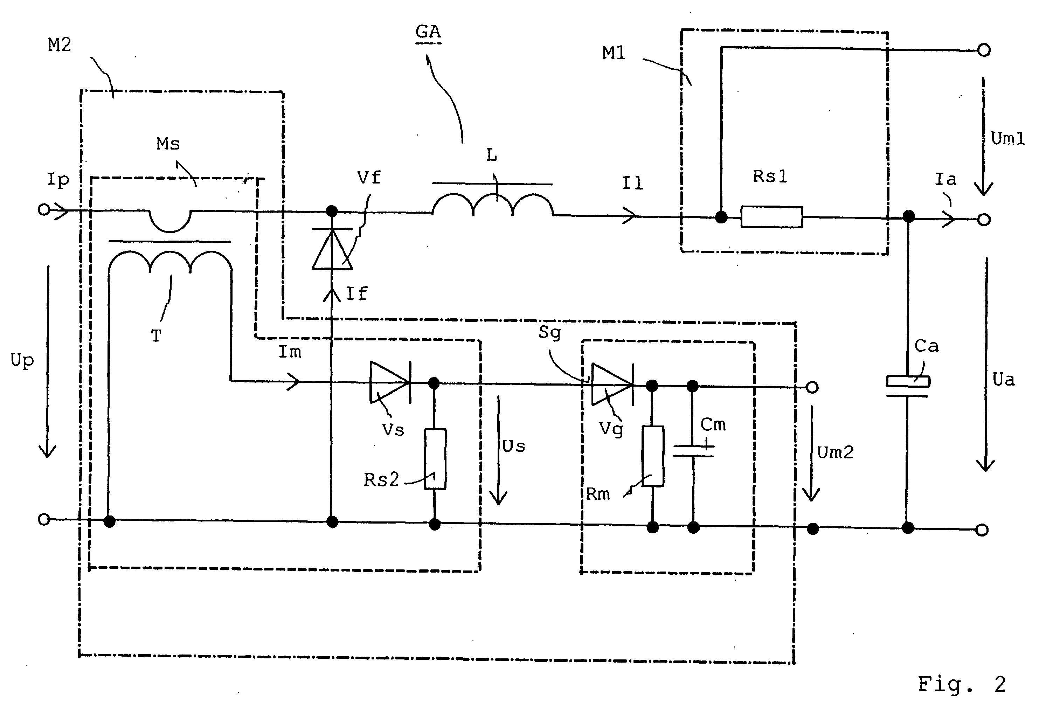

Figur 2 zeigt u.a. die Grundschaltung einer Glättungseinrichtung GA des Pulsstellers PS. Diese enthält eine Glättungsdrossel L mit Freilaufdiode Vf, welcher die gepulste Zwischenspannung Up und der gepulste Zwischenstrom Ip zugeführt werden. Der Wechselanteil dieses Stromes wird von einem erscen Glättungskondensator Ca größtenteils aufgenommen, so daß am Ausgang der Schaltung von Fig.1 eine fast reine Gleichspannung Ua entsteht und der Ausgangsgleichstrom Ia dem mittleren Strom Il durch die Glättungsdrossel L entspricht.

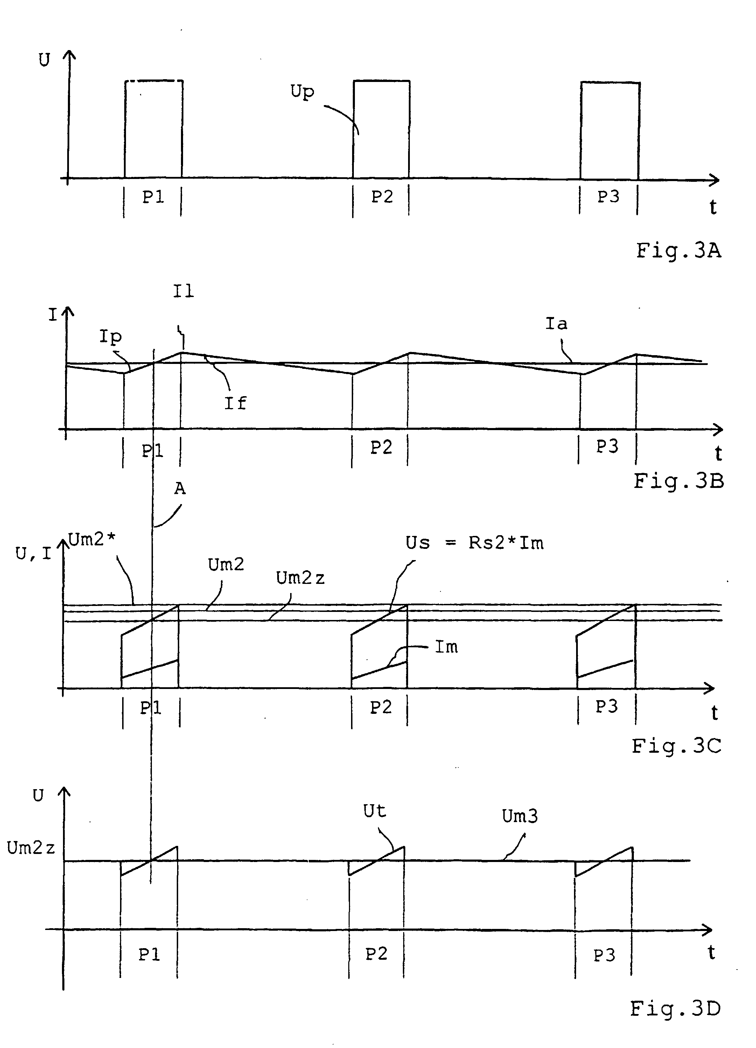

In den Figuren 3A, 3B und 3C sind die Verläufe der wichtigsten elektrischen Signale in der Schaltung von Figur 2 zusammengestellt. So zeigt Figur 3A beispielhaft drei Pulse P1, P2, P3 aus dem Verlauf der gepulsten Zwischenspannung Up am Eingang der Schaltung. In der Figur 3B sind die Verläufe des dreieckförmigen Stromes Il durch die Glättungsdrossel und des Ausgangsgleichstromes Ia dargestellt. Dabei setzt sich der Strom Il durch Glättungsdrossel L aus zwei Komponenten zusammen. Für die Dauer eines der Pulse P1, P2 und P3 entspricht der Strom Il dem Verlauf des gepulscen Zwischenstromes Ip, während er in den Pulspausen dem trapezformigen Strom If durch die Freilaufdiode Vf entspricht.

In der Schaltung von Figur 2 ist ferner eine Komponente M1 enthalten, womit in einer bekannten Weise die aktuelle Größe des Ausgangsgleichstromes Ia erfaßt werden kann. Diese erste Strommeßschaltung M1 enthält einen ersten, vom Strom durch die Glättungsdrossel L durchflossenen Meßwiderstand Rs1, an dem eine erste Meßgleichspannung Um1 abgegriffen werden kann, welche ein Maß für die Größe des Ausgangsgleichstromes Ia ist. Bei dieser Schaltung tritt das bereits angesprochene Problem auf, daß im Meßwiderstand Rs1 erhebliche Verlustleistung vorliegt.

Durch Einsatz einer zweiten Strommeßschaltung M2, welche im Beispiel der Schaltung von Figur 2 ebenfalls bereits dargestellt ist, wird das Auftreten von Verlustleistung im Meßwiderstand durch den Einsatz eines Stromwandlers T nahezu vermieden. Durch eine geeignete Auswahl von dessen Übersetzungsverhältnis kann praktisch für jeden beliebigen Wert des gepulsten Zwischenstromes Ip ein ausreichend großer gepulster Meßstrom Im erzielt werden. Die Strommeßschaltung M2 enthält als eine erste Teilkomponente eine Stromerfassungsschaltung Ms, welche zur Erfassung des gepulsten Zwischenstromes Ip und dessen potentialfreier Umsetzung in einen gepulsten Meßstrom Im auf der Sekundärseite des Stromwandlers T dient. Der gepulste Meßstrom Im wird einer ersten Gleichrichterdiode Vs und einem zweiten Meßwiderstand Rs2 zugeführt. An diesem quasi den Ausgang der Stromerfassungsschaltung Ms bildenden Meßwiderstand trict die gepulste Meßspannung Us auf.

Da der Stromwandler T keine Gleichströme übertragen kann, steht der Meßstrom Im für den zweiten Meßwiderstand Rs2 nur gepulst zur Verfügung. Um wieder ein kontinuierliches Meßsignal zu erhalten, wird dem Stromwandler T ein sogenannter Spitzenwertgleichrichter Sg nachgeschaltet. Ein Beispiel für einen derartigen Spitzenwertgleichrichter Sg ist in der Schaltung von Figur 2 bereits dargestellt und besteht aus einer zweiten Gleichrichterdiode Vg und der Parallelschaltung aus einem Dämpfungswiderstand Rm und einem zweiten Glättungskondensator Cm. Am Ausgang der zweiten Meßschaltung M2 steht dann eine zweite Meßgleichspannung Um2 zur Verfügung.

Dabei tritt aber das Problem auf, daß dieser Spitzenwertgleichrichter Sg zwar aus dem gepulsten Meßstrom Im eine kontinuierliche Meßgleichspannung Um2 erzeugt. Diese hat aber einen Wert, der nur näherungsweise proportional zum gesuchten Mittelwert des Stromes Ip bzw. zum gesuchten Wert von Ia ist. Die Genauigkeit dieser Meßschaltung M2 wird weiter durch die Temperaturabhängigkeit der Flußspannung der zweiten Gleichrichterdiode Vg beeinträchtigt. Anhand der in Figur 3C dargestellten Signalverläufe wird dies nachfolgend näher erläutert. So sind in Figur 3C die Pulse des gepulsten Meßstromes Im dargestellt, welcher auf der Sekundärseite des Stromwandlers T auftritt. Hierdurch wird am zweiten Meßwiderstand Rs2 am Ausgang der Stromerfassungsschaltung Ms eine gepulste Meßspannung Us erzeugt. Es gilt der Zusammenhang Us=Rs2*Im. Aus der gepulsten Meßspannung Us würde durch einen idealen Spitzenwertgleichrichter die Meßgleichspannung Um2* gebildet werden, welche eine dem Spitzenwert der gepulsten Meßspannung Us entsprechende Größe einnehmen wurde. Tatsächlich wird aber auf Grund der nicht idealen Eigenschaften insbesondere der Gleichrichterdiode Vg real die Meßgleichspannung Um2 am Ausgang des Spitzenwertgleichrichters Sg von Figur 2 erzeugt.

Demgegenüber ist es aber das Ziel, eine Meßgleichspannung zu erzeugen, welche eine dem Mittelwert der Pulse der Meßspannung Us in Figur 3C entsprechende Größe aufweist. Eine derartige Meßgleichspannung ist in Figur 3C in Form des Signals Um2z eingetragen. Deren Wert ist proportional dem Mittelwert des gepulsten Meßstromes Im während der Pulse und proportional dem gesuchten Wert des Ausgangsgleichstromes Ia. Die Abweichung des Ausgangssignales Um2 vom Zielwert Um2z encspricht dem Meßfehler der Schaltung von Figur 2.

Der Erfindung liegt die Aufgabe zugrunde, eine Strommeßschaltung der oben genannten Art auf möglichst einfache Weise so weiterzubilden, daß eine Strommessung mit hoher Genauigkeit möglich ist. Insbesondere soll die Weiterbildung ohne den Einsatz von weiteren magnetischen Bauelementen, wie z.B. Stromwandler, moglich sein.

Die Aufgabe wird gelöst mit dem im Anspruch 1 angegebenen Baugruppenträger. Weitere Ausführungsformen der Erfindung sind in den Unteranspruchen angegeben.

Die Erfindung wird an Hand von in den nachfolgend kurz angeführten Figuren dargestellten Ausführungsbeispielen näher erläutert. Dabei zeigt

FIG 1 :        das oben bereits erläuterte Blockschaltbild einer Anordnung zur Erzeugung einstellbarer Ausgangsgleichsignale aus einer Eingangsgleichspannung mittels gepulster Zwischensignale,

FIG 2 :        eine oben bereits erläuterte, bekannte Schaltung zur Gleichrichtung einer gepulsten Zwischenspannung mit zwei Möglichkeiten zur Messung des Ausgangsgleichstromes.

FIG 3A 3B und 3C :    oben bereits erläuterte Verläufe von ausgewahlten Strömen und Spannungen in der Schaltung von Figur 2,

FIG 3D        als Ergänzung zu den Figuren 3A, 3B und 3C die Verläufe von ausgewählten Spannungen in der Schaltung von Figur 4, und

FIG 4 :        eine bevorzugte Ausfuhrungsform einer Ergänzung der Schaltung von Figur 2 gemäß der Erfindung.

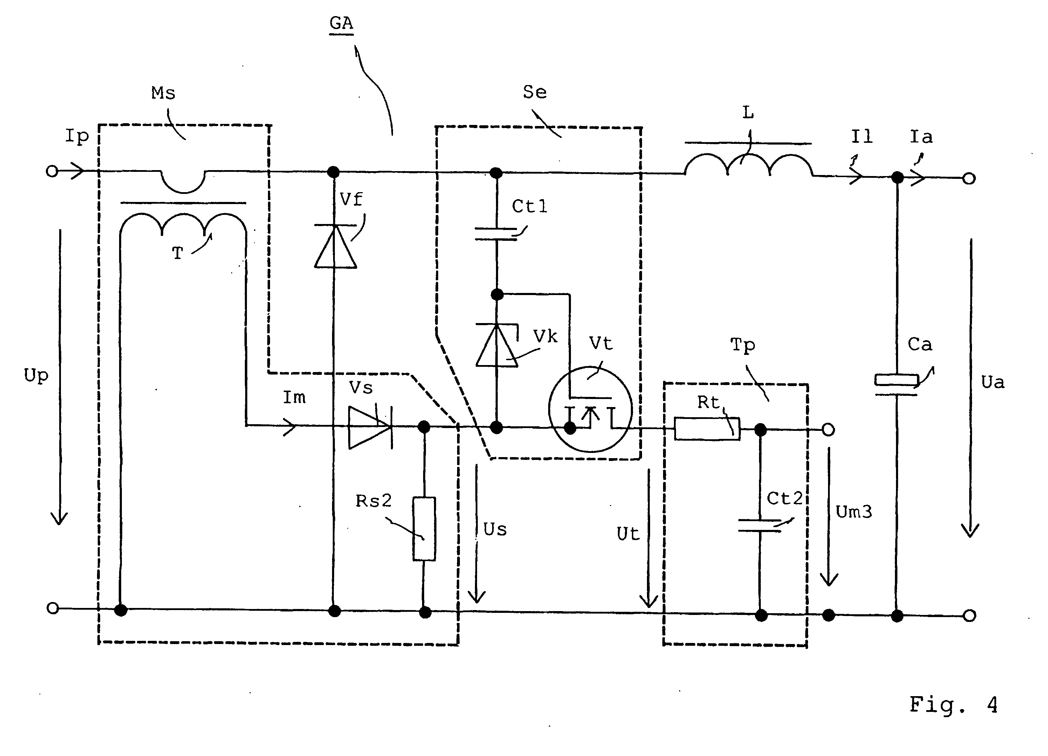

Das Grundprinzip der erfindungsgemäßen Vorrichtung zur Erfassung eines durch einen Pulssteller PS gemäß der Darstellung von Figur 1 erzeugten Ausgangsgleichstromes Ia, wird nachfolgend anhand der Schaltung von Figur 4 näher erläutert. Dort ist eine Glättungseinrichtung GA des Pulsstellers PS dargestellt, deren Grundschaltung der Schaltung von Figur 2 entspricht. Zur besseren Übersicht weisen übereinstimmende Bauelemente und Schaltungsteile in den Figuren 2 und 4 die gleichen Bezugszeichen auf. Der Glättungseinrichtung werden wiederum eine von einer Zerhackereinrichtung gebildete gepulste Zwischenspannung Up und ein gepulster Zwischenstrom Ip zugeführt, und hieraus eine Ausgangsgleichspannung Ua und ein Ausgangsgleichstrom Ia gebildet. Der aktuelle Wert des Ausgangsgleichstromes Ia soll meßtechnisch erfaßt werden.

Hierzu weist die Schaltung von Figur 4 eine Stromerfassungsschaltung Ms auf, welche zur potentialfreien Erfassung und Umwandlung des gepulsten Zwischenstromes Ip in eine gepulste Meßspannung Us dient. Dieses Schaltungsteil ist bevorzugt in der gleichen Weise aufgebaut wie in Figur 2. Erfindungsgemäß schließt sich an die Stromerfassungsschaltung Ms eine von der gepulsten Zwischenspannung Up getaktete Schalteinrichtung Se an. Diese führt die gepulste Meßspannung Us im Takt der gepulsten Zwischenspannung Up einem Tiefpaßfilter Tp zu. Dieses gibt schließlich eine Meßgleichspannung Um3 ab, welche proportional zum gesuchten Wert des Ausgangsgleichstromes Ia ist. Eine Ansteuerschaltung für die getaktete Schalteinrichtung Se besteht bevorzugt aus einer zwischen dem Potential der gepulsten Zwischenspannung Up und dem Potential der gepulsten Meßspannung Us angeordneten Reihenschaltung aus einem Koppelkondensator Ctl und einer Klemmdiode Vk, wobei der Verbindungspunkc zwischen Koppelkondensator und Klemmdiode mit der Steuerelektrode des elektronischen Schalters Vt verbunden ist.

Das Tiefpaßfilter Tp enthält bevorzugt zumindest einen Vorschaltwiderstand Rt und einen Filterkondensator Ct2. Die getaktete Schalteinrichtung Se wird so angesteuert, daß diese jeweils für die Dauer der Pulse des Zwischenstromes Ip schließt. Während dieser Zeit wird durch das Tiefpaßfilter Tp der Mittelwert des gepulsten Zwischenstromes Ip gebildet. In den Pulspausen von Ip bleibt die getaktete Schalteinrichtung Se geöffnet und der Filterkondensator C2 des Tiefpasses behält die vorher gespeicherte Ladung bis zum nächsten Strompuls bei. Unter der Annahme, daß der dreieckförmige Strom Il in der Glättungsdrossel L, welcher wie bereits erläutert, aus den beiden Stromkomponenten Ip und If besteht, während der Dauer eines Pulses der getakteten Zwischenspannung Ip annähernd linear ansteigt (Stromkomponente Ip) und während der Pulspausen wieder annähernd linear abfällt (Stromkomponence If), ergibt sich in beiden Phasen der gleiche Mittelwert. Dieser wird in Form einer dritten Meßspannung Um3 durch das Tiefpaßfilter Tp aus der Spannung Ut am Ausgang der getakteten Schalteinrichtung Se gebildet. Beide Spannungen Um3 und Ut sind in der Figur 3D dargestellt. Bedingt durch die Zuschaltung der getakteten Schalteinrichtung Se entspricht die Spannung Ut während eines der dargestellten Pulse P1, P2 und P3 dem Verlauf der gepulsten Meßspannung Us, bzw. in den Pulspausen dem Mittelwert. Dieser wird durch das Tiefpaßfilter auch während der Pulse erzeugt. Es entsteht somit eine Meßgleichspannung Um3, welche dem idealen Meßwert Um2z nahezu abweichungsfrei entspricht. Der mit der Schaltung nach Figur 4 gebildete Mittelwert entspricht somit dem gewünschten Wert des Ausgangsgleichstromes Ia. Dies kann auch mit folgender Gleichung beschrieben werden :

$$Ia = \frac{Um3}{ü(T)^*Rs2}$$

    Um3: Spannung am Ausgang des Tiefpasses Tp
    ü(T): Übersetzungsverhältnis des Stromwandlers T
    Rs2: Größe des zweiten Meßwiderstandes
    Ia: Ausgangsstrom

Aus obiger Gleichung ist ersichtlich, daß die Genauigkeit der erfindungsgemäßen Meßanordnung nur noch von der Güte des Meßwiderstandes Rs2 abhängig ist. Durch Auswahl eines hochgenauen Meßwiderstandes Rs2 kann somit ein präziser Istwert des Ausgangsgleichstromes Ia aus der Meßgleichspannung Um3 abgeleitet werden.

Es ist besonders vorteilhaft, wenn die getaktete Schalteinrichtung Se in Form einer elektronischen Schaltung realisiert wird. In Figur 4 ist ein Beispiel für eine einfache Art der Realisierung mit Hilfe eines MOS-Transistors Vt dargestellt. Die Ansteuerung des MOS-Transistors Vt erfolgt direkt durch die gepulste Zwischenspannung Up. Der erforderliche Ansteuerpegel für den Transistor Vt kann vorteilhaft abgegriffen werden am Verbindungspunkt einer Reihenschaltung des Koppelkondensators Ct1 mit der Klemmdiode Vk. Der Koppelkondensator Ct1 bildet zusammen mit der Gate-Source-Kapazität des Transistors Vt einen kapazitiven Spannungsteiler. Dadurch ist der Transistor Vt genau während der Pulse der getakteten Zwischenspannung Up eingeschaltet, d.h. wenn ein Puls des Meßstromes Im am zweiten Meßwiderstand Rs2 anliegt.

Bei einer weiteren Ausführung der Erfindung kann dem elektronischen Schalter Vt vorteilhaft auch ein Tiefpaß Tp mit höherer Ordnung nachgeschaltet sein. Hierdurch kann die Meßgenauigkeit der Schaltung noch weiter erhöht werden.

**Patentansprüche**

1.   Vorrichtung zur Erfassung eines durch einen Pulssteller (PS) erzeugten Ausgangsgleichstromes (Ia), wobei

    a) der Pulssteller (PS) zumindest eine Zerhackereinrichtung (Z) zur Bildung einer gepulsten Zwischenspannung (Up) und eines gepulsten Zwischenstromes (Ip) aufweist, welche durch eine Glättungseinrichtung (GA) in eine Ausgangsgleichspannung (Ua) bzw. einen Ausgangsgleichstrom (Ia) umgeformt werden, und mit

    b) einer Stromerfassungsschaltung (Ms) zur potentialfreien Erfassung und Umwandlung des gepulsten Zwischenstromes (Ip) in eine gepulste Meßspannung (Us), und

    c) einer von der gepulsten Zwischenspannung (Up) getakteten Schalteinrichtung (Se), welche die gepulste Meßspannung (Us) im Takt der gepulsten Zwischenspannung (Up) einem Tiefpaßfilter (Tp) zuführt, welches eine zum Ausgangsgleichstrom (Ia) proportionale Meßgleichspannung (Um3) erzeugt.

2.   Vorrichtung nach Anspruch 1, wobei die Stromerfassungsschaltung (Ms) zur potentialfreien Erfassung und Umwandlung des gepulsten Zwischenstromes (Ip) enthält :

    a) einen Stromwandler (T), welcher den gepulsten Zwischenstrom (Ip) in einen gepulsten Meßstrom (Im) umwandelt, und

b). eine erste Gleichrichterdiode (Vs) und einen Meßwiderstand (Rs2), womit der gepulste Meßstrom (Im) in die gepulste Meßspannung (Us) umgewandelt wird.

3. Vorrichtung nach einem der vorangegangenen Ansprüche, wobei die getaktete Schalteinrichtung (Se) einen elektronischen Schalter (Vt) aufweist, insbesondere einen MOS-Transistor, welcher über eine Ansteuerschaltung (Ct1,Vk) durch die gepulste Zwischenspannung (Up) getaktet wird.

4. Vorrichtung nach Anspruch 3, wobei die Ansteuerschaltung (Ct1,Vk) aus einer zwischen der gepulsten Zwischenspannung (Up) und der gepulsten Meßspannung (Us) angeordneten Reihenschaltung aus einem Koppelkondensator (Ct1) und einer Klemmdiode (Vk) besteht, wobei der Verbindungspunkt zwischen Koppelkondensator (Ct1) und Klemmdiode (Vk) mit der Steuerelektrode des elektronischen Schalters (Vt) verbunden ist.

5. Vorrichtung nach einem der vorangegangenen Ansprüche, wobei das Tiefpaßfilter (Tp) mindestens einen Vorschaltwiderstand (Rt) und einen Filterkondensator (Ct2), an dem die Meßgleichspannung (Um3) abgreifbar ist, aufweist.

**Claims**

1. Apparatus for detecting an output direct current (Ia) produced by a pulse controller (PS),

   a) the pulse controller (PS) comprising at least one chopper device (Z) for the formation of a pulsed intermediate voltage (Up) and a pulsed intermediate current (Ip) which are respectively converted to an output d.c. voltage (Ua) and an output direct current (Ia) by a smoothing device (GA), and with

   b) a current detection circuit (Ms) for the potential-free detection and conversion of the pulsed intermediate current (Ip) to a pulsed measurement voltage (Us), and

   c) a switching device (Se), clocked by the pulsed intermediate voltage (Up), which supplies the pulsed measurement voltage (Us), in time with the pulsed intermediate voltage (Up), to a low-pass filter (Tp) which produces a measurement d.c. voltage (Um3) which is proportional to the output direct current (Ia).

2. Apparatus according to Claim 1, the current detection circuit (Ms) for the potential-free detection and conversion of the pulsed intermediate current (Ip) comprising:

   a) a current transformer (T) which converts the pulsed intermediate current (Ip) to a pulsed measurement current (Im), and

   b) a first rectifier diode (Vs) and a measurement resistor (Rs2) which convert the pulsed measurement current (Im) to the pulsed measurement voltage (Us).

3. Apparatus according to any one of the preceding Claims, the clocked switching device (Se) comprising an electronic switch (Vt), in particular, a MOS transistor, which is clocked by the pulsed intermediate voltage (Up) through a drive circuit (Ctl, Vk).

4. Apparatus according to Claim 3, the drive circuit (Ct1, Vk) consisting of a series circuit, formed by a coupling capacitor (Ct1) and a clamping diode (Vk), arranged between the pulsed intermediate voltage (Up) and the pulsed measurement
   voltage (Us), the connection point between the coupling capacitor (Ct1) and the clamping diode (Vk) being connected to the control electrode of the electronic switch (Vt).

5. Apparatus according to any one of the preceding Claims, the low-pass filter (Tp) comprising at least one series resistor (Rt) and one filter capacitor (Ct2) across which the measurement d.c. voltage (Um3) can be tapped.

**Revendications**

1. Dispositif pour la détection d'un courant continu de sortie (la) produit par un régleur d'impulsions (PS),

a) le régleur d'impulsions (PS) comportant au moins un dispositif de hachage (Z) pour la formation d'une tension intermédiaire puisée (Up) et d'un courant intermédiaire pulsé (Ip) qui sont transformés par un dispositif de lissage (GA) respectivement en une tension continue de sortie (Ua) et en un courant continu de sortie (la),

b) avec un circuit de détection de courant (Ms) pour la détection et la transformation sans potentiel du courant intermédiaire pulsé (Ip) en une tension de mesure pulsée (Us), et

c) avec un dispositif commutateur (Se), cadencé par la tension intermédiaire pulsée (Up), qui envoie la tension de mesure pulsée (Us), suivant la cadence de la tension intermédiaire puisée (Up), à un filtre passe-bas (Tp) qui produit une tension continue de mesure (Um3) proportionnelle au courant continu de sortie (la).

2. Dispositif selon la revendication 1, le circuit de détection de courant (Ms) pour la détection et la transformation sans potentiel du courant intermédiaire pulsé (Ip) contenant :

a) un transformateur de courant (T) qui transforme le courant intermédiaire pulsé (Ip) en un courant de mesure pulsé (Im), et

b) une première diode de redressement (Vs) et une résistance série (Rs2) avec lesquelles le courant de mesure pulsé (Im) est transformé en une tension de mesure pulsée (Us).

3. Dispositif selon l'une des revendications précédentes, le dispositif commutateur cadencé (Se) comportant un commutateur électronique (Vt), notamment un transistor MOS, qui est cadencé par l'intermédiaire d'un circuit de commande (Ct1, Vk) par la tension intermédiaire pulsée (Up).

4. Dispositif selon la revendication 3, le circuit de commande (Ct1, Vk) étant constitué d'un circuit série qui est disposé entre la tension intermédiaire pulsée (Up) et la tension de mesure pulsée (Us) et qui est composé d'un condensateur de couplage (Ct1) et d'une diode de verrouillage (Vk), le point de jonction entre le condensateur de couplage (Ct1) et la diode de verrouillage (Vk) étant relié à l'électrode de commande du commutateur électronique (Vt).

5. Dispositif selon l'une des revendications précédentes, le filtre passe-bas (Tp) comportant au moins une résistance additionnelle du côté amont (Rt) et un condensateur de filtrage (Ct2) auquel la tension continue de mesure (Um3) peut être prélevée.

Fig. 1

Fig. 2

EP 0 941 479 B1

U

Up

P1    P2    P3    t

Fig.3A

I

Il

Ip

Ia

If

P1    P2    P3    t

Fig.3B

A

U,I    Um2*

Um2    Um2z    Us = Rs2*Im

Im

P1    P2    P3    t

Fig.3C

U

Ut    Um3

Um2z

P1    P2    P3    t

Fig.3D

Fig. 4

EP 0 941 479 B1

10